# FASCICULE DE BREVET EUROPEEN

(11) **EP 3 377 669 B1**
(45) Date de publication et mention de la délivrance du brevet: **09.10.2019**
(21) Numéro de dépôt: 16809993.5
(22) Date de dépôt: 18.11.2016
(51) Int. Cl.: C23C 14/56, C23C 16/54

(54) **DISPOSITIF POUR LE REVÊTEMENT D'UN OU PLUSIEURS FILS PAR UN PROCÉDÉ DE DÉPÔT EN PHASE VAPEUR**
VORRICHTUNG ZUR BESCHICHTUNG EINES ODER MEHRERER DRÄHTE MITTELS GASPHASENABSCHEIDUNGSVERFAHREN
DEVICE FOR THE COATING OF ONE OR MORE WIRES USING A VAPOUR PHASE DEPOSITION METHOD

(30) Priorité: 19.11.2015 FR 1561150
(43) Date de publication de la demande: 26.09.2018
(73) Titulaire: Safran Ceramics, 33185 Le Haillan (FR)
(72) Inventeur: BUET, Emilien, 33160 Saint Medard en Jalles (FR); THIBAUD, Simon, 33650 La Brède (FR); DELCAMP, Adrien, 33700 Merignac (FR); DESCAMPS, Cédric, 33320 Eysines (FR)
(74) Mandataire: Cabinet Beau de Loménie
(86) Numéro de dépôt international: PCT/FR2016/053008
(87) Numéro de publication internationale: WO 2017/085420

(56) Documents cités:
- EP-A1- 1 277 874
- DE-A1- 3 424 166
- DE-U1- 9 421 895
- FR-A- 1 564 841
- FR-A1- 2 727 435
- US-A1- 2007 099 527

## Description

### Arrière-plan de l'invention

L'invention concerne des dispositifs et procédés pour le revêtement d'un ou plusieurs fils par un procédé de dépôt en phase vapeur.

Les matériaux composites à matrice céramique (CMC) sont mis en oeuvre à des températures de fonctionnement relativement élevées. Ces matériaux comportent un renfort fibreux formé de fils en matériau céramique ou en carbone présent au sein d'une matrice céramique.

Lors de la réalisation de pièces en CMC, une texture fibreuse destinée à former le renfort fibreux de la pièce peut tout d'abord être obtenue par exemple par tissage tridimensionnel. Cette texture fibreuse est ensuite mise en forme afin d'obtenir une préforme fibreuse ayant une forme voisine de celle de la pièce à fabriquer. La préforme est alors densifiée afin de former la matrice et ainsi obtenir la pièce finale, la matrice peut par exemple être en tout ou partie formée par un procédé d'infiltration chimique en phase vapeur (« Chemical Vapor Infiltration » ; « CVI ») ou d'infiltration à l'état fondu (« Melt-Infiltration » ; « MI ») par exemple. Les fils peuvent avant l'étape de mise en forme textile (tissage, tressage...) avoir été revêtus d'un revêtement d'interphase permettant de retarder la rupture de fibres des fils par des fissures qui s'amorcent initialement au sein de la matrice. Le revêtement d'interphase de défragilisation peut, par exemple, être formé d'un matériau de structure lamellaire qui, lorsqu'une fissure parvient à l'interphase, est capable de dissiper l'énergie de fissuration par une déliaison localisée à l'échelle atomique de sorte que la fissure se trouve déviée au sein de l'interphase. Des matériaux constitutifs d'une interphase de défragilisation peuvent par exemple être le carbone pyrolytique (PyC) et le nitrure de bore (BN) qui présentent une structure lamellaire. Le revêtement d'interphase peut par exemple être formé par dépôt chimique en phase vapeur (« Chemical Vapor Déposition » ; « CVD »), infiltration chimique en phase vapeur (« Chemical Vapor Infiltration ») ou encore par voie liquide.

Des dispositifs aptes à réaliser le revêtement en continu d'une pluralité de fils par une interphase par dépôt chimique en phase vapeur ont été proposés dans la littérature. De tels dispositifs peuvent comporter une chambre de traitement au travers de laquelle une pluralité de fils à revêtir sont transportés par entrainement par un système de poulies. Un mélange réactif gazeux est injecté dans la chambre de traitement au travers d'un orifice d'entrée afin former sur les fils le revêtement d'interphase par dépôt chimique en phase vapeur. Le mélange réactif gazeux n'ayant pas réagi ainsi que les sous-produits de réaction sont pompés au travers d'un orifice de sortie lequel est décalé de l'orifice d'entrée le long de l'axe longitudinal de la chambre de traitement. Dans de tels dispositifs, le mélange gazeux injecté s'écoule le long de l'axe longitudinal de la chambre de traitement jusqu'à être pompé au travers de l'orifice de sortie. Des revêtements d'interphase multicouches peuvent être réalisés en plaçant en série plusieurs unités de ce type comprenant un dispositif d'injection d'une phase gazeuse ainsi qu'un dispositif d'évacuation de la phase gazeuse résiduelle.

Toutefois, la fiabilité des procédés connus peut être améliorée dans la mesure où, dans ces procédés, il peut être difficile de maintenir une tension de fils adéquate par le système de poulies et où des vitesses de défilement des fils relativement élevées peuvent être mises en oeuvre lesquelles peuvent aboutir à la sortie de certains fils des gorges des poulies de convoyage.

En outre, il peut être souhaitable de fournir des dispositifs permettant d'augmenter le nombre de fils pouvant être traités par unité de temps.

On connait en outre les documents FR 1 564 841, US 2007/0099527, DE 94 21 895, EP 1 277 874 et DE 34 24 166 qui décrivent des procédés de revêtement de fibres. On connait aussi le document FR 2 727 435 qui décrit un procédé de CVD réactive. Le document FR 1 564 841 décrit un dispositif comportant une chambre de traitement s'étendant le long d'un axe longitudinal et comprenant au moins une zone de traitement, un système de convoyage configuré pour transporter au moins un fil au travers de la zone de traitement, un dispositif d'injection configuré pour injecter une phase gazeuse de traitement, et un dispositif d'évacuation configuré pour évacuer la phase gazeuse résiduelle.

Il existe donc un besoin pour fournir des dispositifs permettant d'améliorer la fiabilité des procédés de revêtement d'un ou plusieurs fils par dépôt en phase vapeur.

Il existe, en outre, un besoin pour fournir des dispositifs permettant d'augmenter le nombre de fils pouvant être traités par unité de temps.

### Objet et résumé de l'invention

A cet effet, l'invention propose, selon un premier aspect, un dispositif pour le revêtement d'un ou plusieurs fils par un procédé de dépôt en phase vapeur, comportant au moins :
- une chambre de traitement s'étendant le long d'un axe longitudinal et comprenant au moins une zone de traitement située entre une paroi circonférentielle interne et une paroi circonférentielle externe et dans laquelle au moins un fil est destiné à être revêtu par mise en oeuvre d'un procédé de dépôt en phase vapeur,
- un système de convoyage configuré pour transporter ledit au moins un fil au travers de la zone de traitement,
- un dispositif d'injection configuré pour injecter une phase gazeuse de traitement dans la zone de traitement au travers d'au moins un orifice d'entrée présent sur la paroi circonférentielle interne ou externe, et
- un dispositif d'évacuation configuré pour évacuer la phase gazeuse résiduelle hors de la zone de traitement au travers d'au moins un orifice de sortie présent sur la paroi circonférentielle interne ou externe, ledit orifice d'entrée et ledit orifice de sortie étant situés sur un même plan perpendiculaire à l'axe longitudinal de la chambre de traitement et étant décalés le long de la direction circonférentielle de la chambre de traitement.

Ledit plan perpendiculaire à l'axe longitudinal de la chambre de traitement intersecte une partie de l'orifice d'entrée et de l'orifice de sortie. Ce plan peut ou non intersecter l'orifice d'entrée et l'orifice de sortie au niveau de leur centre. Il est donc possible que l'orifice d'entrée et l'orifice de sortie soient légèrement décalés le long de l'axe longitudinal de la chambre de traitement tant qu'une partie de ces orifices est située sur un même plan perpendiculaire à cet axe longitudinal.

Le dispositif selon l'invention présente avantageusement une longueur ainsi qu'un encombrement réduits. L'invention permet, du fait de la longueur réduite du dispositif, d'imposer plus facilement une tension de fil adéquate lors du dépôt en phase vapeur. En outre, le fait que la chambre de traitement présente une longueur réduite par rapport aux dispositifs de l'art antérieur permet avantageusement de mettre en oeuvre des vitesses de défilement plus faibles sans pour autant augmenter la durée de traitement des fils, ce qui permet avantageusement de réduire le risque que le ou les fils ne se désolidarisent du système de convoyage. En outre, il est avantageusement possible de contrôler de manière plus fiable les conditions du dépôt en phase vapeur dans la zone de traitement étant donné la longueur réduite de celle-ci. Par ailleurs, la mise en oeuvre d'une zone de traitement de forme annulaire située entre une paroi circonférentielle interne et une paroi circonférentielle externe peut avantageusement permettre de positionner les fils à traiter le long de la circonférence de la zone de traitement et ainsi d'augmenter la quantité de fils traités par unité de temps par rapport au cas où ces fils sont positionnés le long du diamètre d'une chambre de traitement.

Le dispositif peut en outre comporter un système de chauffage configuré pour chauffer la zone de traitement.

Dans un exemple de réalisation, le dispositif peut comprendre une pluralité d'orifices d'entrée ainsi qu'une pluralité d'orifices de sortie.

Un tel exemple de réalisation permet avantageusement de recouvrir de manière homogène un nombre relativement élevé de fils.

Dans un exemple de réalisation, les orifices d'entrée et les orifices de sortie peuvent être décalés de manière à ce que chacun des orifices de sortie soit positionné entre deux orifices d'entrée le long de la direction circonférentielle.

Dans un exemple de réalisation, lesdits orifices d'entrée et lesdits orifices de sortie peuvent être uniformément répartis le long de la direction circonférentielle.

Un tel exemple de réalisation permet avantageusement d'améliorer encore l'homogénéité du revêtement formé sur les différents fils traités.

Dans un exemple de réalisation, le ou les orifices d'entrée peuvent être situés sur la paroi circonférentielle interne, respectivement externe, et le ou les orifices de sortie peuvent être situés sur la paroi circonférentielle externe, respectivement interne. En d'autres termes dans ce cas lorsque les orifices d'entrée sont situés sur la paroi circonférentielle interne, les orifices de sortie sont situés sur la paroi circonférentielle externe et, lorsque les orifices d'entrée sont situés sur la paroi circonférentielle externe, les orifices de sortie sont situés sur la paroi circonférentielle interne.

Un tel exemple de réalisation permet avantageusement d'améliorer encore l'homogénéité du revêtement formé sur les différents fils traités.

Dans un exemple de réalisation, le système de convoyage peut comporter un élément de réglage de la vitesse de défilement dudit au moins un fil au travers de la chambre de traitement.

Une telle caractéristique permet avantageusement de facilement faire varier l'épaisseur de la ou des couches formée(s) en modifiant la vitesse de défilement dudit au moins un fil au travers de la zone de traitement.

Dans un exemple de réalisation, le dispositif peut comporter au moins un élément ajouré présent dans la chambre de traitement délimitant latéralement la zone de traitement et des joints d'étanchéité présents entre ledit élément ajouré et la paroi circonférentielle interne ou externe de la chambre de traitement. Le dispositif peut dans un exemple de réalisation présenter au moins un premier et un deuxième éléments ajourés de ce type, le premier élément ajouré étant présent en regard de la paroi circonférentielle interne et le deuxième élément ajouré étant présent en regard de la paroi circonférentielle externe.

La présente invention vise également un procédé de revêtement d'un ou plusieurs fils par un procédé de dépôt en phase vapeur mettant en oeuvre un dispositif tel que décrit plus haut, le procédé comportant au moins les étapes suivantes :
- injection de la phase gazeuse dans la zone de traitement par le dispositif d'injection au travers dudit orifice d'entrée,
- transport d'au moins un fil au travers de la zone de traitement par le système de convoyage afin de former une couche sur ledit au moins un fil par dépôt en phase vapeur à partir de la phase gazeuse injectée, et
- évacuation de la phase gazeuse résiduelle hors de la zone de traitement au travers dudit orifice de sortie.

Le dépôt de ladite couche peut avoir lieu alors que ledit au moins un fil est mis en mouvement par le système de convoyage au travers de la zone de traitement.

Dans un exemple de réalisation, ledit au moins un fil peut être transporté en continu par le système de convoyage au travers de la chambre de traitement. En d'autres termes, ledit au moins un fil ne s'arrête pas lors de son trajet au travers de la chambre de traitement. Dans ce cas, ledit au moins un fil est, sur toute la durée de son trajet au travers de la chambre de traitement, animé d'une vitesse non nulle.

Dans un exemple de réalisation, ledit au moins un fil peut effectuer un unique passage au travers de la chambre de traitement.

Le procédé de dépôt en phase vapeur mis en oeuvre peut être un dépôt chimique en phase vapeur (« CVD »), un dépôt chimique en phase vapeur réactive (« Reactive Chemical Vapor Déposition » ; « RCVD ») ou un dépôt physique en phase vapeur (« Physical Vapor Déposition » ; « PVD »).

Dans un exemple de réalisation, la couche peut être formée par dépôt chimique en phase vapeur (addition de matière sur la surface des fils) ou par dépôt chimique en phase vapeur réactive (transformation de la matière présente à la surface des fils).

Dans un exemple de réalisation, la couche peut être une couche d'un revêtement d'interphase.

La couche d'un revêtement d'interphase est, par exemple, en pyrocarbone (PyC), nitrure de bore (BN), carbone dopé au bore (BC), nitrure de silicium (Si₃N₄), ou en un carbure mixte de bore et silicium (Si-B-C).

La présente invention vise encore un procédé de fabrication d'une pièce en matériau composite comprenant au moins les étapes suivantes :
- revêtement d'une pluralité de fils par un revêtement d'interphase au moins par mise en oeuvre d'un procédé tel que décrit plus haut,
- formation d'une préforme fibreuse par mise en oeuvre d'une ou plusieurs opérations textiles à partir des fils ainsi revêtus par le revêtement d'interphase, et
- densification de la préforme fibreuse par une matrice afin d'obtenir une pièce en matériau composite.

De préférence, la préforme fibreuse est obtenue par tissage, par exemple par tissage tridimensionnel, à partir des fils revêtus par le revêtement d'interphase.

La matrice peut comporter un matériau céramique comme du carbure de silicium ou être en carbone. La matrice peut être formée par tout type de procédé connu comme l'infiltration chimique en phase vapeur (« Chemical Vapor Infiltration ») ou l'infiltration à l'état fondu (« Melt-Infiltration »), par exemple.

La pièce formée peut, par exemple, être une aube de turbomachine ou un secteur d'anneau de turbine, par exemple.

### Brève description des dessins

D'autres caractéristiques et avantages de l'invention ressortiront de la description suivante de modes particuliers de réalisation de l'invention, donnés à titre d'exemples non limitatifs, en référence aux dessins annexés, sur lesquels :
- la figure 1 représente schématiquement une section d'un dispositif selon l'invention perpendiculairement à l'axe longitudinal de la chambre de traitement,
- la figure 2 représente schématiquement le dispositif de la figure 1 en coupe le long de l'axe longitudinal de la chambre de traitement,
- la figure 3 est une vue en coupe le long de l'axe longitudinal de la chambre de traitement au niveau d'un orifice d'entrée représentant un détail du dispositif de la figure 1, et
- la figure 4 est une vue en coupe le long de l'axe longitudinal de la chambre de traitement au niveau d'un orifice de sortie représentant un détail du dispositif de la figure 1.

### Description détaillée de modes de réalisation

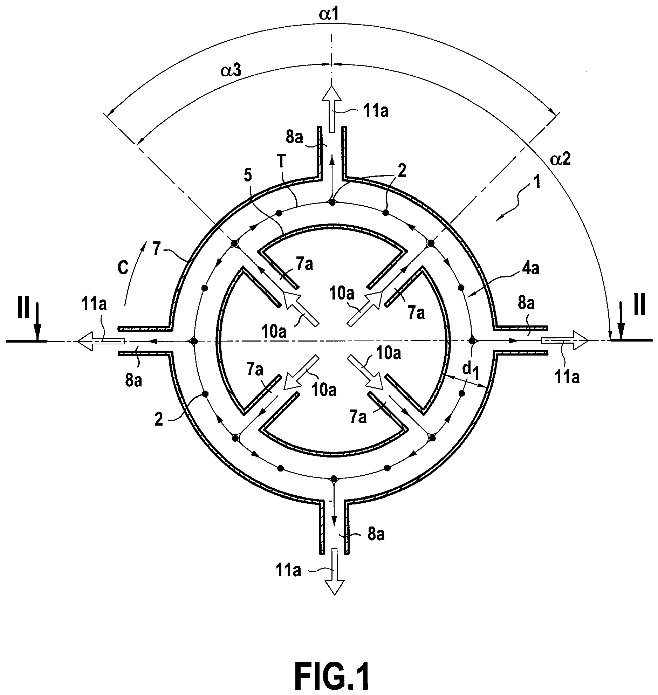

On a représenté à la figure 1 un dispositif 1 selon l'invention permettant le revêtement d'une pluralité de fils 2 par un procédé de dépôt en phase vapeur.

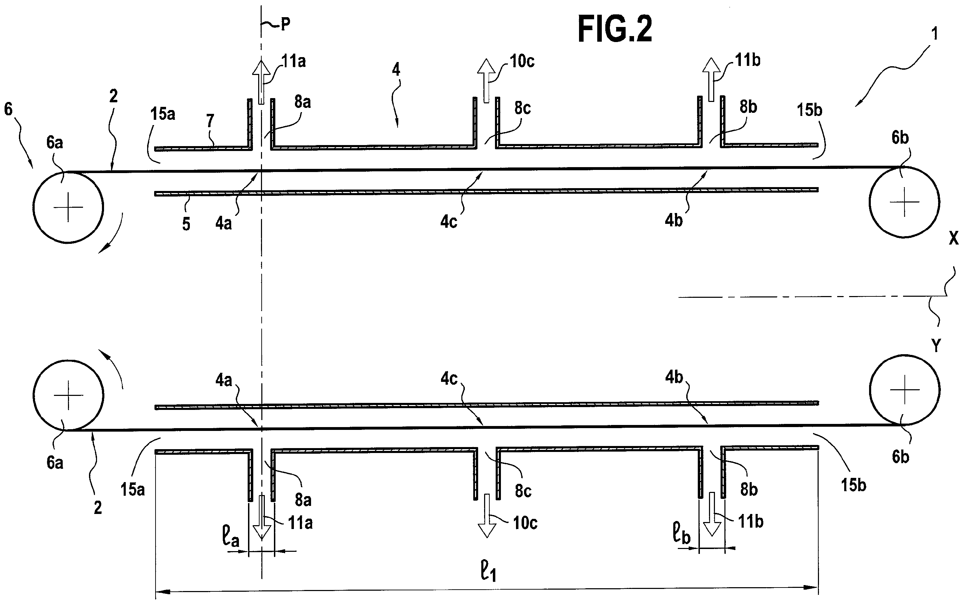

Comme illustré à la figure 1 notamment, le dispositif 1 comporte une chambre de traitement définissant une première zone de traitement 4a dans laquelle les fils 2 sont destinés à être revêtus par mise en oeuvre d'un procédé de dépôt en phase vapeur. Les fils 2 destinés à être revêtus dans la première zone de traitement 4a ne sont pas liés entre eux (en particulier ces fils ne sont pas tissés, tricotés ou tressés). Ces fils 2 n'ont pas subi d'opération textile et ne forment pas une structure fibreuse. Les fils 2 peuvent être formés d'un matériau céramique, par exemple d'un matériau oxyde, nitrure, carbure, par exemple de carbure de silicium (SiC). En variante, les fils 2 peuvent être des fils de carbone. Dans un exemple de réalisation, une partie des fils 2 est formée d'un matériau céramique et une partie des fils 2 est en carbone. Dans un exemple de réalisation, au moins 20 fils, par exemple entre 20 et 200 fils peuvent être traités simultanément dans la première zone de traitement 4a. La première zone de traitement 4a est présente entre une paroi circonférentielle interne 5 et une paroi circonférentielle externe 7. La chambre de traitement 4 est délimitée radialement par la paroi circonférentielle interne 5 et par la paroi circonférentielle externe 7. La première zone 4a présente une forme annulaire lorsqu'observée en section perpendiculairement à l'axe longitudinal de la chambre de traitement. Dans l'exemple illustré à la figure 1, la première zone 4a a une forme générale circulaire lorsqu'observée en section perpendiculairement à l'axe longitudinal de la chambre de traitement. On ne sort toutefois pas du cadre de l'invention lorsque la première zone a une autre forme comme une forme générale elliptique ou polygonale, par exemple rectangulaire ou carrée, lorsqu'observée en section perpendiculairement à l'axe longitudinal de la chambre de traitement. Les fils 2 sont répartis de manière circonférentielle dans la première zone 4a. Une telle répartition des fils 2 le long de la circonférence de la première zone 4a permet avantageusement d'augmenter le nombre de fils traités par unité de temps par rapport à une répartition des fils le long du diamètre de la zone de traitement. Le dispositif 1 comporte en outre un premier dispositif d'injection (non représenté) configuré pour injecter une première phase gazeuse de traitement 10a dans la première zone 4a au travers d'une pluralité d'orifices d'entrée 7a présents sur la paroi circonférentielle interne 5. Dans l'exemple illustré, chaque orifice d'entrée 7a est présent sur la paroi circonférentielle interne 5. Le dispositif 1 comporte en outre un premier dispositif d'évacuation (non représenté) configuré pour évacuer la première phase gazeuse résiduelle 11a hors de la première zone 4a au travers d'une pluralité d'orifices de sortie 8a présents sur la paroi circonférentielle externe 7. Dans l'exemple illustré, chaque orifice de sortie 8a est présent sur la paroi circonférentielle externe 7. Le premier dispositif d'évacuation est configuré pour évacuer la première phase gazeuse résiduelle hors de la chambre de traitement. Afin de réaliser l'évacuation de la première phase gazeuse résiduelle, les orifices de sortie 8a sont chacun en relation avec des moyens d'aspiration tels qu'une pompe à vide (non représentée). Les orifices d'entrée 7a et les orifices de sortie 8a sont chacun situés sur un même plan perpendiculaire à l'axe longitudinal de la chambre de traitement (ce plan correspondant au plan de coupe de la figure 1 et ce plan P est représenté à la figure 2). En outre, les orifices d'entrée 7a et les orifices de sortie 8a sont décalés le long de la direction circonférentielle C de la chambre de traitement. Plus précisément, dans l'exemple de la figure 1, chaque orifice de sortie 8a est positionné entre deux orifices d'entrée 7a consécutifs le long de la direction circonférentielle C. En d'autres termes, lorsque l'on se déplace dans la zone 4a le long de la direction circonférentielle C, il y a alternance entre les orifices d'entrée 7a et les orifices de sortie 8a, c'est-à-dire que l'on passe successivement en regard d'un orifice d'entrée 7a puis d'un orifice de sortie 8a puis d'un orifice d'entrée 7a et ainsi de suite. Par ailleurs, dans l'exemple illustré, les orifices d'entrée 7a et les orifices de sortie 8a sont uniformément répartis le long de la direction circonférentielle C. La figure 1 illustre le trajet de la première phase gazeuse dans la première zone 4a (trajet fléché T). Du fait de l'aspiration réalisée au niveau des orifices de sortie 8a, la première phase gazeuse est présente le long d'un anneau dans la première zone 4a lorsque la première zone 4a est observée en section perpendiculairement à l'axe longitudinal de la chambre de traitement. Ce trajet de la première phase gazeuse permet de traiter de manière homogène les fils positionnés de manière annulaire dans la première zone 4a.

L'écart angulaire α₁ entre deux orifices d'entrée 7a consécutifs le long de la direction circonférentielle C peut être supérieur ou égal à 15°. L'écart angulaire α₁ peut être inférieur ou égal à 90°, en particulier cet écart angulaire peut être compris entre 15° et 90°. Dans l'exemple illustré, cet écart angulaire est sensiblement égal à 90°. Le nombre d'orifices d'entrée 7a peut être supérieur ou égal à 4. Le nombre d'orifices d'entrée 7a peut être inférieur ou égal à 25 et par exemple être compris entre 4 et 25. La distance d₁ entre la paroi circonférentielle interne 5 et la paroi circonférentielle externe 7 peut être supérieure ou égale à 0,02 m. Cette distance d₁ peut être inférieure ou égale à 0,1 m et par exemple être comprise entre 0,02 m et 0,1 m. La distance d₁ est mesurée perpendiculairement à l'axe longitudinal de la chambre de traitement. L'écart angulaire α₂ entre deux orifices de sortie 8a consécutifs le long de la direction circonférentielle C peut être supérieur ou égal à 15°. L'écart angulaire α₂ peut être inférieur ou égal à 180°, en particulier cet écart angulaire peut être compris entre 15° et 180°. Dans l'exemple illustré, cet écart angulaire est sensiblement égal à 90°. Le rapport entre le nombre d'orifices de sortie 8a et le nombre d'orifices d'entrée 7a peut être compris entre 0,5 et 1. Avantageusement, ce rapport est égal à 1 afin d'obtenir un revêtement particulièrement homogène entre les différents fils traités. Le nombre d'orifices de sortie 8a peut être supérieur ou égal à 2. Le nombre d'orifices de sortie 8a peut être inférieur ou égal à 25 et par exemple être compris entre 2 et 25. L'écart angulaire α₃ entre un orifice d'entrée 7a et l'orifice de sortie 8a consécutif le long de la direction circonférentielle C peut être supérieur ou égal à 7,5°. L'écart angulaire α₃ peut être inférieur ou égal à 135°, en particulier cet écart angulaire peut être compris entre 7,5° et 135°. Sauf mention contraire, l'écart angulaire entre deux orifices correspond à l'écart angulaire entre les centres de ces deux orifices.

Dans une variante non illustrée, les orifices d'entrée peuvent être présents sur la paroi circonférentielle externe et les orifices de sortie sur la paroi circonférentielle interne. Les propriétés décrites ci-dessus notamment en termes d'agencement relatif des orifices d'entrée et de sortie et d'écart angulaire sont applicables à ce dernier exemple de réalisation. Dans une variante non illustrée, on peut avoir un unique orifice d'entrée et un unique orifice de sortie, par exemple situé à une position diamétralement opposée à la position de l'orifice d'entrée.

La chambre de traitement 4 s'étend entre une première extrémité d'entrée 15a et une deuxième extrémité de sortie 15b le long d'un axe longitudinal X (voir figure 2). La figure 2 illustre en outre le plan P perpendiculaire à l'axe longitudinal X sur lequel sont situés les orifices d'entrée 7a et de sortie 8a.

La chambre de traitement 4 peut, par exemple, présenter une longueur l₁ supérieure ou égale à 0,5 mètre et par exemple comprise entre 0,5 mètre et 5 mètres. La longueur l₁ de la chambre de traitement 4 correspond à la distance séparant l'extrémité d'entrée 15a de l'extrémité de sortie 15b mesurée le long de l'axe longitudinal X. La première zone de traitement 4a peut quant à elle présenter une longueur lₐ mesurée le long de l'axe longitudinal X supérieure ou égale à 0,01 mètre et par exemple comprise entre 0,01 mètre et 0,2 mètre.

Le dispositif 1 comporte, en outre, un système de convoyage 6 comprenant, dans l'exemple illustré, une pluralité de poulies 6a et 6b. Un premier ensemble de poulies 6a est situé en regard de l'extrémité d'entrée 15a et un deuxième ensemble de poulies 6b est situé en regard de l'extrémité de sortie 15b. Le premier ensemble de poulies 6a et le deuxième ensemble de poulies 6b sont positionnés de manière annulaire autour de l'axe longitudinal X. Les fils 2 sont tendus entre les poulies 6a et 6b et sont tendus entre les extrémités d'entrée et de sortie 15a et 15b. Le système de convoyage 6 est configuré pour transporter les fils 2 dans la chambre de traitement 4 au travers de la première zone 4a le long d'un axe de convoyage Y. L'axe de convoyage Y est, dans l'exemple illustré, parallèle à l'axe longitudinal X. L'axe de convoyage Y est représenté comme rectiligne dans l'exemple illustré à la figure 2. Le système de convoyage 6 est configuré pour transporter les fils 2 au travers de la chambre de traitement 4 sur toute la longueur I₁ de celle-ci. Les parois circonférentielles interne 5 et externe 7 s'étendent chacune le long de l'axe longitudinal X de la chambre de traitement 4. Le système de convoyage 6 est configuré pour transporter les fils 2 entre la paroi circonférentielle interne 5 et la paroi circonférentielle externe 7.

La chambre de traitement 4 peut en outre définir une deuxième zone de traitement 4b laquelle est décalée de la première zone de traitement 4a le long de l'axe longitudinal X et le long de l'axe de convoyage Y comme illustré à la figure 2. La deuxième zone de traitement 4b présente les mêmes propriétés que la première zone de traitement 4a en termes de positionnement du ou des orifice(s) d'entrée et de sortie 8b. La présence de cette deuxième zone de traitement 4b est optionnelle. Lorsque la chambre 4 définit une deuxième zone de traitement 4b, le dispositif 1 peut en outre comporter un deuxième dispositif d'injection configuré pour injecter dans la deuxième zone de traitement 4b une deuxième phase gazeuse de traitement différente de la première phase gazeuse de traitement au travers d'au moins un orifice d'entrée. Toujours dans ce cas, le dispositif 1 peut en outre comporter un deuxième dispositif d'évacuation configuré pour évacuer la deuxième phase gazeuse résiduelle 11b hors de la deuxième zone 4b au travers d'au moins un deuxième orifice de sortie 8b. Le ou les orifice(s) d'entrée et de sortie débouchant dans la deuxième zone 4b sont situés sur un même plan perpendiculaire à l'axe longitudinal X et sont décalés le long de la direction circonférentielle de la chambre de traitement. Lors de leur transport par le système de convoyage 6, les fils 2 traversent la première zone 4a puis la deuxième zone 4b. La deuxième zone de traitement 4b peut présenter une longueur l_{b} mesurée le long de l'axe longitudinal X supérieure ou égale à 0,01 mètre et par exemple comprise entre 0,01 mètre et 0,2 mètre.

Dans l'exemple illustré à la figure 2, la chambre de traitement 4 définit en outre une zone barrière 4c située entre les première 4a et deuxième 4b zones le long de l'axe de convoyage Y. La zone barrière 4c est destinée à être traversée par les fils 2 lors de leur transport par le système de convoyage 6. Dans l'exemple illustré à la figure 2, les fils 2 traversent successivement la première zone 4a, puis la zone barrière 4c puis la deuxième zone 4b lors de leur transport par le système de convoyage 6. La présence de cette zone barrière 4c est optionnelle. Le dispositif 1 comporte, en outre, dans l'exemple illustré un dispositif d'injection d'une phase gazeuse inerte (non représenté) configuré pour injecter une phase gazeuse inerte 10c dans la zone barrière 4c. La phase gazeuse inerte 10c est injectée au travers d'au moins un orifice d'entrée de la phase gazeuse inerte. La phase gazeuse inerte 10c est évacuée hors de la zone barrière 4c et hors de la chambre de traitement 4 par un dispositif d'évacuation de la phase gazeuse inerte (non représenté) au travers d'au moins un orifice de sortie 8c de la phase gazeuse inerte. L'agencement des orifices d'entrée et de sortie de la phase gazeuse inerte peut être identique à l'agencement des orifices d'entrée et de sortie relatifs aux première et deuxième zones. La phase gazeuse inerte peut par exemple comporter du N₂ et/ou de l'argon (Ar). La phase gazeuse inerte présente dans la zone barrière fait office de « rideau gazeux » permettant, si cela est souhaité, de réduire, voire d'éviter, le mélange entre les première et deuxième phases gazeuses.

L'exemple de dispositif 1 illustré à la figure 2 comporte une chambre de traitement 4 définissant deux zones de traitement 4a et 4b, une couche distincte étant formée par un procédé de dépôt en phase vapeur dans chacune de ces zones 4a et 4b. Un tel dispositif 1 permet de former un revêtement bicouches sur les fils 2 par dépôt en phase vapeur. La présence de la zone barrière 4c permet quant à elle d'éviter un mélange des première et deuxième phases gazeuses et permet ainsi d'obtenir une interface nette entre les deux couches formées dans les première et deuxième zones 4a et 4b.

Dans une variante non illustrée, la chambre de traitement définit une unique zone de traitement, un tel dispositif permettant de former un revêtement monocouche sur les fils par dépôt en phase vapeur. En variante encore, la chambre de traitement définit au moins trois zones de traitement afin de former un revêtement comprenant au moins trois couches. Dans une variante non illustrée, on peut s'affranchir de la présence de la zone barrière 4c.

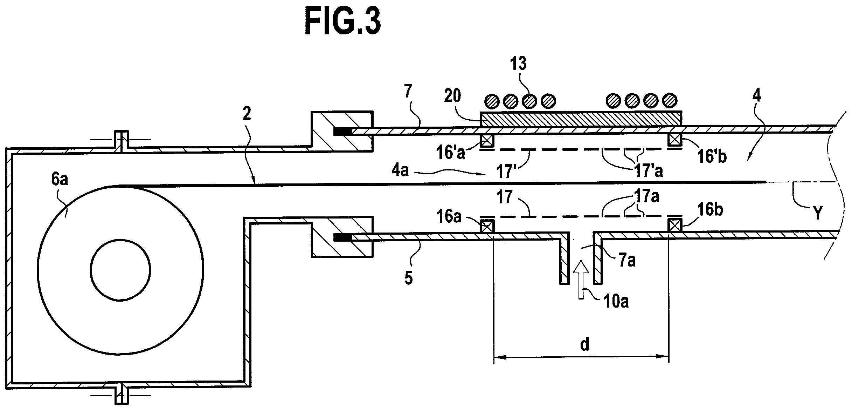

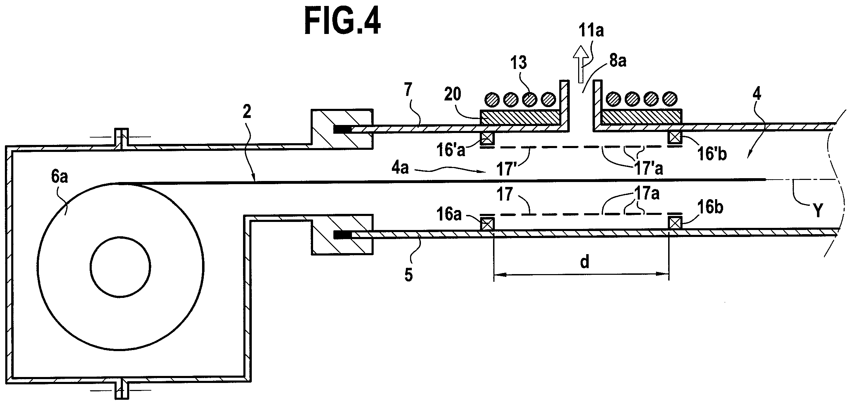

Il a été représenté aux figures 3 et 4 un détail du dispositif 1 illustré aux figures 1 et 2 au niveau de la première zone de traitement 4a étant entendu que la même structure est présente au niveau de la deuxième zone de traitement 4b lorsque celle-ci est présente. La figure 3 est une vue partielle du dispositif 1 en coupe longitudinale au niveau d'un orifice d'entrée 7a et la figure 4 est une vue partielle du dispositif 1 en coupe longitudinale au niveau d'un orifice de sortie 8a. Le dispositif 1 comprend un système de chauffage configuré pour chauffer la première zone de traitement 4a afin de réaliser le dépôt en phase vapeur. Plus précisément, le système de chauffage comporte un suscepteur 20 ainsi qu'un inducteur 13. Le suscepteur 20 est présent, dans l'exemple illustré, à l'extérieur de la chambre de traitement 4 et entoure la première zone 4a. Dans l'exemple illustré, le suscepteur 20 chauffe la paroi circonférentielle externe 7 délimitant la chambre de traitement 4 afin de chauffer la première zone 4a et réaliser le dépôt en phase vapeur. On peut en outre placer en regard de la paroi circonférentielle interne 5 un système de chauffage additionnel (chauffage résistif ou par induction, non représenté aux figures 3 et 4). Le suscepteur 20 est couplé inductivement avec un inducteur 13 situé lui aussi à l'extérieur de la chambre de traitement 4. Une première et une deuxième grilles ajourées 17 et 17' présentant chacune une pluralité d'ajours traversants 17a et 17'a sont présentes dans la chambre de traitement 4. La première grille ajourée 17 est présente en regard des orifices d'entrée 7a (voir figure 3) et la deuxième grille ajourée 17' est présente en regard des orifices de sortie 8a (voir figure 4). Ces grilles 17 et 17' ont chacune une forme annulaire lorsqu'observées en section perpendiculairement à l'axe longitudinal X. La première grille ajourée 17 permet d'assurer une communication fluidique entre les orifices d'entrée 7a et la zone de traitement 4a. La deuxième grille ajourée 17' permet d'assurer une communication fluidique entre la zone de traitement 4a et les orifices de sortie 8a. Ainsi, la première zone de traitement 4a est délimitée radialement par la première grille ajourée 17 et par la deuxième grille ajourée 17'. La première zone 4a est située entre les première et deuxième grilles ajourées 17 et 17'. Des premiers joints d'étanchéité amont 16a et aval 16b sont présents entre la première grille ajourée 17 et la paroi circonférentielle interne 5. Des deuxièmes joints d'étanchéité amont 16'a et aval 16'b sont présents entre la deuxième grille ajourée 17' et la paroi circonférentielle externe 7. Les premiers joints d'étanchéité 16a et 16b permettent de canaliser la première phase gazeuse 10a vers la première zone 4a. Les deuxièmes joints d'étanchéité 16'a et 16'b permettent quant à eux de canaliser la première phase gazeuse résiduelle 11a vers les orifices de sortie 8a.

Lors de la mise en oeuvre du procédé de revêtement en phase vapeur, la première phase gazeuse 10a est injectée au travers des orifices d'entrée 7a et s'écoule ensuite au travers des ajours 17a de la première grille ajourée 17 afin de pénétrer dans la première zone 4a dans laquelle le dépôt en phase vapeur est réalisé. Comme mentionné plus haut, une fois dans la première zone 4a, la première phase gazeuse est présente dans cette zone 4a le long d'un anneau. La première phase gazeuse résiduelle 11a s'écoule ensuite au travers des ajours 17'a de la deuxième grille ajourée 17' en direction des orifices de sortie 8a afin d'être évacuée. La première zone 4a est délimitée le long de l'axe de convoyage Y par les premiers joints d'étanchéité amont et aval 16a et 16b. En d'autres termes, la longueur lₐ de la première zone 4a est inférieure ou égale à la distance d séparant le premier joint d'étanchéité amont 16a du premier joint d'étanchéité aval 16b, la longueur lₐ et la distance d étant mesurées le long de l'axe de convoyage Y.

Dans une variante non illustrée, le suscepteur est présent dans la chambre de traitement 4 et délimite latéralement la première zone. Dans ce cas, le suscepteur présente une pluralité d'ajours traversants et est par exemple positionné à la place de la deuxième grille ajourée.

Afin de réaliser le revêtement de fils 2 par un revêtement d'interphase, il est possible de mettre en oeuvre le procédé suivant. Les fils 2 sont tout d'abord transportés au travers de la première zone 4a. La première phase gazeuse 10a est injectée au travers des premiers orifices d'entrée 7a par le premier dispositif d'injection alors que les fils 2 sont transportés continûment au travers de la première zone 4a. Le traitement par la première phase gazeuse 10a permet de former sur les fils 2 lors de leur transport au travers de la première zone 4a, une première couche d'un revêtement d'interphase par dépôt chimique en phase vapeur à partir de la première phase gazeuse. Les fils revêtus de la première couche du revêtement d'interphase traversent ensuite la zone barrière 4c puis sont transportés par le système de convoyage 6 jusqu'à la deuxième zone de traitement 4b. Dans cette deuxième zone 4b, une deuxième phase gazeuse de traitement 10b est injectée au travers des orifices d'entrée par le deuxième dispositif d'injection afin de former, sur les fils revêtus de la première couche, une deuxième couche d'un revêtement d'interphase par dépôt chimique en phase vapeur à partir de la deuxième phase gazeuse. Les phases gazeuses permettant le dépôt chimique en phase vapeur comprennent un ou plusieurs précurseurs du matériau de la couche à former. Les phases gazeuses peuvent comporter un unique gaz ou un mélange de gaz. Lorsqu'un revêtement d'interphase en carbone est destiné à être formé, les phases gazeuses peuvent comporter un ou plusieurs hydrocarbures gazeux, par exemple choisis parmi le méthane, l'éthane, le propane et le butane. Les phases gazeuses peuvent en variante comporter un précurseur gazeux d'un matériau céramique comme du méthyltrichlorosilane. Afin de réaliser un dépôt donné, le choix du ou des précurseurs à mettre en oeuvre ainsi que les conditions de pression et de température à imposer dans la chambre de traitement 4 font partie des connaissances générales de l'homme du métier. Les fils 2 sont transportés en continu par le système de convoyage 6 entre la première extrémité d'entrée 15a et la deuxième extrémité de sortie 15b de la chambre de traitement 4. En outre, les fils 2 effectuent un unique passage au travers de la chambre de traitement 4 dans l'exemple illustré (pas de retour vers la première extrémité 15a une fois que les fils ont atteint la deuxième extrémité 15b). A titre d'exemple, la vitesse de défilement imposée aux fils 2 durant tout ou partie de leur trajet au travers de la chambre de traitement 4 peut être supérieure ou égale à 0,01 mètre/minute. La vitesse de défilement imposée aux fils 2 durant tout ou partie de leur trajet au travers de la chambre de traitement 4 peut être inférieure ou égale à 2 mètres/minute et par exemple être comprise entre 0,01 mètre/minute et 2 mètres/minute. Comme mentionné plus haut, le système de convoyage 6 peut avantageusement comporter un élément de réglage de la vitesse de défilement des fils 2 au travers de la chambre de traitement 4. En faisant varier la vitesse de défilement des fils 2, un utilisateur peut ainsi modifier le temps de séjour des fils dans la ou les zones de traitement et par conséquent modifier l'épaisseur de la ou des couches formées sur les fils. Une fois la vitesse de défilement fixée, l'homme du métier est en mesure de déterminer à partir de ses connaissances générales les valeurs des débits des phases gazeuses à mettre en oeuvre afin d'obtenir le dépôt en phase vapeur recherché. A titre d'exemple, le débit de la première phase gazeuse injectée et/ou le débit de la deuxième phase gazeuse injectée peut être supérieur ou égal à 0,01 litre/minute, par exemple compris entre 0,01 litre/minute et 50 litres/minute.

### Exemple

Un revêtement d'interphase de nitrure de bore (BN) a été déposé par un procédé de dépôt en phase vapeur sur une pluralité de fils défilant dans une zone de traitement d'une chambre de traitement du type de celle illustrée à la figure 1. Les fils sont des fils de carbone ou des fils en matériau céramique (fils SiC ou Si-C-O, comme des fils Nicalon®, Hi-Nicalon® ou Hi-Nicalon® Type S de la société Nippon Carbon). Une phase gazeuse de traitement a été injectée dans la zone de traitement au travers des orifices d'entrée 7a et la phase gazeuse résiduelle a été évacuée de ladite zone au travers des orifices de sortie 8a. Les écarts angulaires α₁ et α₂ étaient de 36° et l'écart angulaire α₃ de 18°. Il y avait donc 10 orifices d'entrée et 10 orifices de sortie. La longueur de l'arc séparant deux orifices d'entrée consécutifs le long de la direction circonférentielle était de 0,15 m. Le diamètre de la paroi circonférentielle externe 7 était de 0,5 m et le diamètre de la paroi circonférentielle interne 5 de 0,45 m. La valeur de la vitesse de défilement des fils dans la zone de traitement a été imposée à 50 millimètres/minute. La longueur de chauffe (i.e. la longueur du suscepteur) était de 220 mm et le diamètre du suscepteur était de 550 mm. Les paramètres suivants ont été imposés pour réaliser le dépôt en phase vapeur :
- température de 1100 °C,
- coefficient alpha (correspondant au rapport (débit volumique de NH₃)/(débit volumique de BCl₃)) de 1,3,
- coefficient bêta (correspondant au rapport (débit volumique de N₂)/(débit volumique de BCl₃ + débit volumique de NH₃)) de 1,
- pression totale de 0,2 kPa,
- temps de séjour de 87 millisecondes,
- durée du traitement de 300 minutes.

Plus précisément, les débits suivants ont été imposés pour la phase gazeuse de traitement (ces débits sont indiqués pour l'alimentation de l'ensemble des 10 orifices d'entrée) :
- H₂ : 2,02 L/min
- NH₃ : 1,14 L/min
- BCl₃ : 0,88 L/min
- Total : 4,03 L/min

Ces conditions de traitement ont permis d'obtenir un revêtement d'interphase de nitrure de bore ayant une épaisseur de 300 nm hautement cristallisé et homogène, concentrique dans son épaisseur et sa longueur de dépôt.

L'expression « compris(e) entre ... et ... » ou « allant de ... à ... » doit se comprendre comme incluant les bornes.

## Revendications

1. Dispositif (1) pour le revêtement d'un ou plusieurs fils (2) par un procédé de dépôt en phase vapeur, comportant au moins :
- une chambre de traitement (4) s'étendant le long d'un axe longitudinal (X) et comprenant au moins une zone de traitement (4a) située entre une paroi circonférentielle interne (5) et une paroi circonférentielle externe (7) et dans laquelle au moins un fil (2) est destiné à être revêtu par mise en oeuvre d'un procédé de dépôt en phase vapeur,
- un système de convoyage (6) configuré pour transporter ledit au moins un fil (2) au travers de la zone de traitement (4a),
- un dispositif d'injection configuré pour injecter une phase gazeuse de traitement (10a) dans la zone de traitement (4a) au travers d'au moins un orifice d'entrée (7a) présent sur la paroi circonférentielle interne (5) ou externe (7),
- un dispositif d'évacuation configuré pour évacuer la phase gazeuse résiduelle (11a) hors de la zone de traitement (4a) au travers d'au moins un orifice de sortie (8a) présent sur la paroi circonférentielle interne (5) ou externe (7), ledit orifice d'entrée (7a) et ledit orifice de sortie (8a) étant situés sur un même plan (P) perpendiculaire à l'axe longitudinal (X) de la chambre de traitement (4) et étant décalés le long de la direction circonférentielle (C) de la chambre de traitement (4).

2. Dispositif (1) selon la revendication 1, comprenant une pluralité d'orifices d'entrée (7a) ainsi qu'une pluralité d'orifices de sortie (8a).

3. Dispositif (1) selon la revendication 2, dans lequel les orifices d'entrée (7a) et les orifices de sortie (8a) sont décalés de manière à ce que chacun des orifices de sortie (8a) soit positionné entre deux orifices d'entrée (7a) le long de la direction circonférentielle (C).

4. Dispositif (1) selon l'une quelconque des revendications 2 et 3, lesdits orifices d'entrée (7a) et lesdits orifices de sortie (8a) étant uniformément répartis le long de la direction circonférentielle (C).

5. Dispositif (1) selon l'une quelconque des revendications 1 à 4, le ou les orifices d'entrée (7a) étant situés sur la paroi circonférentielle interne (5), respectivement externe (7), et le ou les orifices de sortie (8a) étant situés sur la paroi circonférentielle externe (7), respectivement interne (5).

6. Dispositif (1) selon l'une quelconque des revendications 1 à 5, le système de convoyage (6) comportant un élément de réglage de la vitesse de défilement dudit au moins un fil (2) au travers de la chambre de traitement (4).

7. Procédé de revêtement d'un ou plusieurs fils (2) par un procédé de dépôt en phase vapeur mettant en oeuvre un dispositif (1) selon l'une quelconque des revendications 1 à 6, le procédé comportant au moins les étapes suivantes :
- injection de la phase gazeuse (10a) dans la zone de traitement (4a) par le dispositif d'injection au travers dudit orifice d'entrée (7a),
- transport d'au moins un fil (2) au travers de la zone de traitement (4a) par le système de convoyage (6) afin de former une couche sur ledit au moins un fil (2) par dépôt en phase vapeur à partir de la phase gazeuse injectée (10a), et
- évacuation de la phase gazeuse résiduelle (11a) hors de la zone de traitement (4a) au travers dudit orifice de sortie (8a).

8. Procédé selon la revendication 7, dans lequel ledit au moins un fil (2) est transporté en continu par le système de convoyage (6) au travers de la chambre de traitement (4).

9. Procédé selon l'une quelconque des revendications 7 et 8, dans lequel la couche est formée par dépôt chimique en phase vapeur ou par dépôt chimique en phase vapeur réactive.

10. Procédé selon l'une quelconque des revendications 7 à 9, la couche étant une couche d'un revêtement d'interphase.

11. Procédé de fabrication d'une pièce en matériau composite comprenant au moins les étapes suivantes :
- revêtement d'une pluralité de fils (2) par un revêtement d'interphase au moins par mise en oeuvre d'un procédé selon la revendication 10,
- formation d'une préforme fibreuse par mise en oeuvre d'une ou plusieurs opérations textiles à partir des fils ainsi revêtus par le revêtement d'interphase, et
- densification de la préforme fibreuse par une matrice afin d'obtenir une pièce en matériau composite.

## Patentansprüche

1. Vorrichtung (1) zur Beschichtung von einem oder mehreren Fäden (2) durch ein Verfahren zur Gasphasenabscheidung, die mindestens umfasst:
- eine Behandlungskammer (4), die sich entlang einer Längsachse (X) erstreckt und mindestens eine Behandlungszone (4a) umfasst, die sich zwischen einer inneren Umfangswand (5) und einer äußeren Umfangswand (7) befindet und in der mindestens ein Faden (2) dazu bestimmt ist, durch die Umsetzung eines Verfahrens zur Gasphasenabscheidung beschichtet zu werden,
- ein Fördersystem (6), das dazu ausgestaltet ist, den mindestens einen Faden (2) durch die Behandlungszone (4a) zu transportieren,
- eine Einspritzvorrichtung, die dazu ausgestaltet ist, eine Gasphase (10a) zur Behandlung in die Behandlungszone (4a) durch mindestens eine Eingangsöffnung (7a) einzuspritzen, die an der inneren (5) oder äußeren (7) Umfangswand vorliegt,
- eine Ablassvorrichtung, die dazu ausgestaltet ist, die verbleibende Gasphase (11a) aus der Behandlungszone (4a) durch mindestens eine Ausgangsöffnung (8a) abzulassen, die an der inneren (5) oder äußeren (7) Umfangswand vorliegt, wobei sich die Eingangsöffnung (7a) und die Ausgangsöffnung (8a) auf der gleichen Ebene (P) befinden, die zu der Längsachse (X) der Behandlungskammer (4) senkrecht verläuft, und entlang der Umfangsrichtung (C) der Behandlungskammer (4) versetzt sind.

2. Vorrichtung (1) nach Anspruch 1, die mehrere Eingangsöffnungen (7a) sowie mehrere Ausgangsöffnungen (8a) umfasst.

3. Vorrichtung (1) nach Anspruch 2, wobei die Eingangsöffnungen (7a) und die Ausgangsöffnungen (8a) so versetzt sind, dass jede der Ausgangsöffnungen (8a) entlang der Umfangsrichtung (C) zwischen zwei Eingangsöffnungen (7a) positioniert ist.

4. Vorrichtung (1) nach einem der Ansprüche 2 und 3, wobei die Eingangsöffnungen (7a) und die Ausgangsöffnungen (8a) gleichmäßig entlang der Umfangsrichtung (C) verteilt sind.

5. Vorrichtung (1) nach einem der Ansprüche 1 bis 4, wobei sich die Eingangsöffnung(en) (7a) an der inneren (5) bzw. der äußeren (7) Umfangswand befindet/en, und sich die Ausgangsöffnung(en) (8a) an der äußeren (7) bzw. der inneren (5) Umfangswand befindet/en.

6. Vorrichtung (1) nach einem der Ansprüche 1 bis 5, wobei das Fördersystem (6) ein Element zur Regelung der Geschwindigkeit des Durchlaufs des mindestens einen Fadens (2) durch die Behandlungskammer (4) umfasst.

7. Verfahren zur Beschichtung von einem oder mehreren Fäden (2) durch ein Verfahren zur Gasphasenabscheidung, das eine Vorrichtung (1) nach einem der Ansprüche 1 bis 6 umsetzt, wobei das Verfahren zumindest die folgenden Schritte umfasst:
- Einspritzen der Gasphase (10a) in die Behandlungszone (4a) durch die Einspritzvorrichtung durch die Eingangsöffnung (7a),
- Transportieren von mindestens einem Faden (2) durch die Behandlungszone (4a) durch das Fördersystem (6), um eine Schicht auf dem mindestens einen Faden (2) durch Gasphasenabscheidung ausgehend von der eingespritzten Gasphase (10a) zu bilden, und
- Ablassen der verbleibenden Gasphase (11a) aus der Behandlungszone (4a) durch die Ausgangsöffnung (8a).

8. Verfahren nach Anspruch 7, wobei der mindestens eine Faden (2) kontinuierlich von dem Fördersystem (6) durch die Behandlungskammer (4) transportiert wird.

9. Verfahren nach einem der Ansprüche 7 und 8, wobei die Schicht durch chemische Gasphasenabscheidung oder durch chemische reaktive Gasphasenabscheidung gebildet wird.

10. Verfahren nach einem der Ansprüche 7 bis 9, wobei die Schicht eine Schicht einer Interphasenbeschichtung ist.

11. Verfahren zur Herstellung eines Teils aus Verbundmaterial, das zumindest die folgenden Schritte umfasst:
- Beschichten von mehreren Fäden (2) durch eine Interphasenbeschichtung zumindest durch die Umsetzung eines Verfahrens nach Anspruch 10,
- Bilden einer faserigen Vorform durch die Umsetzung von einem oder mehreren Textilvorgängen ausgehend von den auf diese Weise durch die Interphasenbeschichtung beschichteten Fäden, und
- Verdichten der faserigen Vorform durch ein Gesenk, um ein Teil aus Verbundmaterial zu erhalten.

## Claims

1. A device (1) for coating one or more yarns (2) by a vapor deposition method, comprising at least:
- a treatment chamber (4) extending along a longitudinal axis (X) and having at least one treatment zone (4a) situated between an internal circumferential wall (5) and an external circumferential wall (7), and within which at least one yarn (2) is to be coated by performing a vapor deposition method;
- a conveyor system (6) configured to transport said at least one yarn (2) through the treatment zone (4a);
- an injector device configured to inject a treatment gas phase (10a) into the treatment zone (4a) through at least one inlet orifice (7a) present in the internal or external circumferential wall (5 or 7); and
- a removal device configured to remove the residual gas phase (11a) from the treatment zone (4a) through at least one outlet orifice (8a) present in the internal or external circumferential wall (5 or 7), said inlet orifice (7a) and said outlet orifice (8a) being situated in a common plane (P) perpendicular to the longitudinal axis (X) of the treatment chamber (4) and being offset around the circumferential direction (C) of the treatment chamber (4).

2. A device (1) according to claim 1, having a plurality of inlet orifices (7a) and a plurality of outlet orifices (8a) .

3. A device (1) according to claim 2, wherein the inlet orifices (7a) and the outlet orifices (8a) are offset so that each of the outlet orifices (8a) is positioned between two inlet orifices (7a) around the circumferential direction (C).

4. A device (1) according to claim 2 or claim 3, said inlet orifices (7a) and said outlet orifices (8a) being uniformly distributed around the circumferential direction (C).

5. A device (1) according to any one of claims 1 to 4, the inlet orifice(s) (7a) being situated respectively in the internal or external circumferential wall (5 or 7), and the outlet orifice(s) (8a) being situated respectively in the external or internal circumferential wall (7 or 5).

6. A device (1) according to any one of claims 1 to 5, the conveyor system (6) including an element for adjusting the travel speed of said at least one yarn (2) through the treatment chamber (4).

7. A method of treating one or more yarns (2) by a vapor deposition method by using a device (1) according to any one of claims 1 to 6, the method comprising at least the following steps:
- using the injector device to inject the gas phase (10a) into the treatment zone (4a) through said inlet orifice (7a);
- using the conveyor system (6) to cause at least one yarn (2) to be transported through the treatment zone (4a) so as to form a layer on said at least one yarn (2) by vapor deposition from the injected gas phase (10a); and
- removing the residual gas phase (11a) from the treatment zone (4a) through said outlet orifice (8a).

8. A method according to claim 7, wherein said at least one yarn (2) is transported continuously by the conveyor system (6) through the treatment chamber (4).

9. A method according to claim 7 or claim 8, wherein the layer is formed by chemical vapor deposition or by reactive chemical vapor deposition.

10. A method according to any one of claims 7 to 9, wherein the layer is an interphase coating layer.

11. A method of fabricating a composite material part, the method comprising at least the following steps:
- coating a plurality of yarns (2) with an interphase coating at least by performing a method according to claim 10;
- forming a fiber preform by performing one or more textile operations on yarns as coated in this way with the interphase coating; and
- densifying the fiber preform with a matrix in order to obtain a composite material part.
